# EUROPEAN PATENT SPECIFICATION

(11) **EP 4 210 441 B1**
(45) Date of publication and mention of the grant of the patent: **11.03.2026**
(21) Application number: 22150834.4
(22) Date of filing: 11.01.2022
(51) Int. Cl.: H05K 7/14

(54) **PRESSURE RELIEF OF CABINET FOR ELECTRICAL EQUIPMENT**
DRUCKENTLASTUNG VON SCHRÄNKEN FÜR ELEKTRISCHE GERÄTE
DÉCOMPRESSION D'ARMOIRE POUR ÉQUIPEMENT ÉLECTRIQUE

(43) Date of publication of application: 12.07.2023
(73) Proprietor: ABB SCHWEIZ AG, 5400 Baden (CH)
(72) Inventor: WEISS, Michael, 5507 Mellingen (CH); STEMMLER, Christoph, 5415 Nussbaumen (CH); GRIESSER, Stefan, 79771 Klettgau (DE); ANDERHUB, Christoph, 4312 Magden (CH)
(74) Representative: Sykora & König Patentanwälte PartG mbB

(56) References cited:
- DE-U1- 202020 101 874
- US-A1- 2007 285 889
- US-A1- 2017 181 298

## Description

### FIELD OF THE INVENTION

The invention relates to a cabinet for power electronics components.

### BACKGROUND OF THE INVENTION

For traction and other applications, power electronic components are arranged inside cabinets, which protect the power electronic components from environmental conditions and also prevent a direct access of the power electronic components.

There is a possibility that explosions or rapid pressure buildup occur inside such a cabinet. The reason may be an internal arc fault or combustible gas produced by pyrolysis of plastic material in capacitors, transformers or chokes that are ignited inside the closed cabinet. Such a combustible gas mix may get ignited due to local high temperatures in the faulty component or a mechanical switch actuation.

A further possibility for a combustible gas mix is a thermal runaway of battery cells with gas combustion inside or outside the cells.

To mitigate such explosions and to generate a controlled pressure relief, a lot of additional members are known, which can be added to the housing. Such members may include rupture discs, burst panels, explosion vents, burst flaps, shutter flaps, pressure relief vanes, flameless exhaust elements, etc. In some cases, the housings themselves allow gas exchange via openings with or without filters or membranes permeable for gases.

DE 202020 101874 U1 shows a casing for a power electronics device, with a closure that on one side is enforced. The closure is screwed to a trough of the casing. When an explosion takes place and the closure lifts off, the enforced side stays attached to the trough, while the other sides are intended to detach.

US 2017/181298 A1 shows a housing for receiving electronic components. A housing body and a housing cover are connected to each other at a multiple of fastening points. Some of the fastening points are surrounded by a recess, so that in the event of an internal pressure, a gap is formed there between the housing body and the housing cover.

It is an objective of the invention to provide a simple to manufacture and economic cabinet for power electronics components.

This objective is achieved by the subject-matter of the independent claim.

Further exemplary embodiments are evident from the dependent claims and the following description.

The invention relates to a cabinet for power electronics components. A cabinet may be an enclosure and/or housing, which is made of sheet metal or other material for enclosing components, and in particular in this case power electronics components. The cabinet may have a substantially cuboid shape. An example for such a cabinet is a cabinet enclosing the components of a traction converter, which cabinet is located in a railcar of a train.

The power electronics components, which also may be seen as power electrical equipment, may comprise at least one of batteries, inverter components and/or switch gear components. The cabinet may be a converter cabinet. The cabinet may be the housing of a battery pack.

The term "power" may relate to electric applications and/or components, which process more than 10 A, in particular more than 100 A, and/or more than 100 V, in particular more than 1000 V.

According to an embodiment of the invention, the cabinet comprises walls for enclosing an interior of the cabinet, in which the power electronics components are arranged. The walls may be made of aluminium or an alloy thereof and/or may be attached to each other or a frame. Each wall may be substantially flat.

The power electronics components may be hermetically sealed inside the interior of the cabinet. There may be no openings in the walls of the cabinet, which allow a substantial gas exchange with the environment.

One of the walls comprises a panel, which is attached with each of its edges to the wall with a plurality of attachment devices. The edges of the panel may circumvent the border of the panel. The panel may be made of sheet metal and/or may be substantially flat. The panel may be made of aluminium or an alloy thereof.

The wall may have an opening, which is covered by the panel. The panel may overlap the opening at its edges. Panel may be a cover. The panel may be a service cover and/or may be detached, such as by screwing, for maintenance of the cabinet.

The attachment devices may comprise screws, nuts, bolts and/or rivets. The panel may be riveted to the wall and/or may be screwed to the wall. Each attachment device may press a part of the panel and a part of the wall together.

According to an embodiment of the invention, one edge of the edges is stronger attached to the wall than the other edges, such that in case of an explosion in the interior of the cabinet, due to a pressure on the panel, the other edges detach from the wall, the one edge stays attached to the wall and the panel bends away from the wall around the one edge. Stronger attached may mean that a higher force is necessary to detach the one edge from the wall than the other edges. It may be that at least a section of the one edge or the complete one edge is stronger attached to the wall. Also several sections of the one edge may be stronger attached to the wall.

Such a design may mitigate sudden high pressure due to fault events in a closed cabinet. The design may prevent parts of the cabinet from flying around. The cabinet with the pressure relief panel is a simple design without the need for further members. The pressure relief panel may be integrated in screwed enclosure covers, which also may be used for service of the cabinet. The design is cost effective and may even be retrofitted to existing cabinets on site. The design does not need for maintenance or inspection for working properly.

The detachment force of the one edge and the lower detachment force of the other edges may be chosen, such that the one edge stays attached and that a detachment of the other edges occurs, when a typical explosion takes place in the interior of the cabinet.

The material strength of the panel and/or of the wall at the attachment may be chosen, such that after the detachment of the other edges, the panel bents away from the wall, when a typical explosion takes place in the interior of the cabinet.

According to an embodiment of the invention, the one edge is one of the longest edges of the panel. The panel may have an elongated shape and the stronger attached edge may be one of the longer edges. This may reduce the risk that a part of the panel tearing off the rest of the panel.

According to an embodiment of the invention, the panel is a rectangular panel and/or may have a substantially rectangular shape. The panel may have two longer edges and two shorter edges.

At each edge of the panel, the attachment devices may be distributed evenly. However, at the one edge, which is stronger attached, each of the attachment devices may be stronger and/or there may be more attachment devices. In general, at all edges, the attachment devices may have a spacing optimized for water and dust tightness and/or EMC requirements.

As specific examples, the attachment strength at the one edge may be increased by adding more screws and/or by increasing the resistance to unbuttoning of blind rivet nuts.

According to an embodiment of the invention, a density of the attachment devices at the one edge is higher than at the other edges. The number of attachment devices per area may be higher at the one edge. There may be a different pattern of attachment devices at the one edge and at the other edges. At the one edge, the pattern may be that the distance between attachment devices is shorter than as the other edges.

According to an embodiment of the invention, the attachment devices at the one edge are equally designed and wherein the attachment devices at the other edges are equally designed. One possibility is to always use the same attachment devices but to increase their density at the one edge.

According to an embodiment of the invention, the attachment devices are arranged in rows along the edges. There may be one single row of attachment devices along each edge.

According to an embodiment of the invention, a distance of neighbouring attachment devices at the one edge is shorter than a distance of neighbouring attachment devices at the other edges. The spacing of attachment devices at the one edge may be decreased. For example, there may be twice as many attachment devices on the one edge per unit length as on the other edges. Such a design may be retrofitted by adding an attachment device between two already present attachment devices at the one edge.

According to an embodiment of the invention, each attachment device comprises an interior part with an interior rim pressed towards an interior side of the wall and an exterior part with an exterior rim connected to the interior part and pressed against an outer side of the panel. Each attachment device may comprise an interior part and an exterior part, which are connected with each other during assembling.

For example, the interior part is a rivet blind head and the exterior part is a rivet head, the interior part is a nut and the exterior part is a screw. Also combinations thereof are possible, i.e. that the interior part comprises a rivet blind head and/or a nut, for example may be a blind rivet nut. The exterior part also may comprise a rivet head and/or a screw.

According to an embodiment of the invention, each attachment device protrudes through the panel and the wall. Each of the panel and the wall may comprise a through hole, through which a bolt of the attachment device reaches.

For example, a blind rivet nut may be provided on the wall side, to which the panel is screwed with a screw from the panel side. The connection of the blind rivet nut to an aluminium sheet, i.e. the wall, of the cabinet body may be the weakest link. In general, the wall, the part of the attachment device protruding through the wall and panel or the panel may be chosen as weakest link, which is detached during an explosion.

According to an embodiment of the invention, at the one edge, a reinforcement plate is arranged between the wall and the interior rim of the interior part of at least some of the attachment devices. The reinforcement plate may be a washer, a substantially quadratic plate or a strip.

The strength of the attachment of the attachment devices may be increased along the one edge of the panel, by supporting the panel and/or the wall.

An example for achieving this is by backing an aluminium sheet of the wall with an extra strip of steel through which blind rivet nuts are inserted. A doubling sheet out of a stronger material may be added in the clinch of the blind rivet nut. In such a way, the unbuttoning strength of selected screws of the panel may be increased.

According to an embodiment of the invention, at the one edge, additionally or alternatively, a reinforcement plate is arranged between the panel and an exterior rim of the exterior part of at least some of the attachment devices. For example, a washer, quadratic plate or strip may be arranged between a head (such as a screw head) of the attachment devices and the panel.

It has to be noted that also at the other edges, such a reinforcement plate may be present. However, at the other edges, which should be weaker, the one or more reinforcement plates are then weaker as the one or more reinforcement plates at the one edge of the plate, which should be reinforced.

According to an embodiment of the invention, the at least some of the attachment device protrude through the reinforcement plate. The reinforcement plate may comprise one or more through holes through which a bolt of one or more of the attachment devices reaches.

According to an embodiment of the invention, the reinforcement plate is made of steel. The reinforcement plate may be made of a material, such as steel, which is stiffer and/or stronger than a material of the panel and/or the wall, to which the panel is attached, such as aluminium. "Stiffer" and/or stronger may mean that the material is less easy to bend and/or to deform than the other material. In this way, at the edge, where the reinforcement plate is provided, the attachment of the panel to the wall is more resistant than at the other edges.

According to an embodiment of the invention, at the one edge and the other edges, a sealing strip is arranged between the wall and the panel. The sealing strip may be used to prevent ingress of water and other fluids. In addition, it may help that gases, which are generated inside the cabinet, do not leave the cabinet between the panel and the wall in an uncontrolled way. The sealing strip may run along the complete outer border, i.e. all edges, of the panel. The sealing strip may be made of a ring. The material of the sealing strip may be plastics material and/or rubber.

These and other aspects of the invention will be apparent from and elucidated with reference to the embodiments described hereinafter.

### BRIEF DESCRIPTION OF THE DRAWINGS

The subject-matter of the invention will be explained in more detail in the following text with reference to exemplary embodiments which are illustrated in the attached drawings.
Fig. 1 shows a perspective view of a cabinet according to an embodiment of the invention.
Fig. 2 shows a side view of a cabinet according to a further embodiment of the invention.
Fig. 3 shows a cross-sectional view of a part of a cabinet according to a further embodiment of the invention.
Fig. 4 and 5 show perspective views of parts of the cabinet of Fig. 3.

The reference symbols used in the drawings, and their meanings, are listed in summary form in the list of reference symbols. In principle, identical parts are provided with the same reference symbols in the figures.

### DETAILED DESCRIPTION OF EXEMPLARY EMBODIMENTS

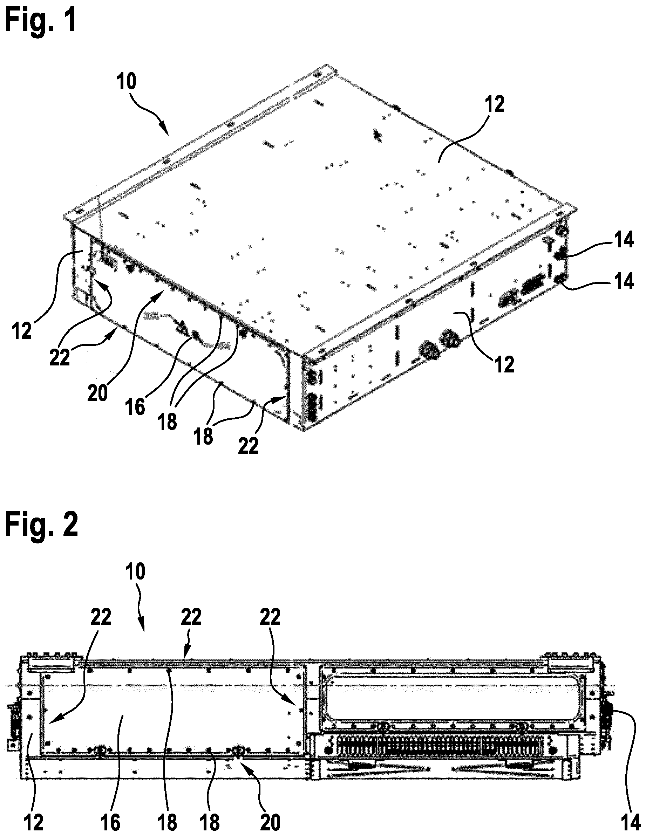

Fig. 1 and 2 show different embodiments of a cabinet 10 with a substantially cuboid shape, which is composed of walls 12, which may be made of aluminium alloy or other sheet material. Exemplarily, two terminals 14 are shown in Fig. 1, which are connected to power electronics components in the interior of the cabinet 10.

One of the walls 12 comprises a panel 16, which is attached with a plurality of attachment devices 18 to the respective wall 12. The panel may be made of aluminium alloy or other sheet material, in particular the same material as the walls 12. Each of the attachment devices 18 comprises a screw, which is screwed to a blind rivet nut inside the cabinet at an opposite side of the wall 12. However, other types of attachment devices 18 may also be used.

The panel 16 has a substantially rectangular shape. The attachment devices 18 are aligned in rows along the edges 20, 22 of the panel.

One edge 20 is stronger attached to the wall 12 than the other edges 22, such that in case of an explosion in the interior of the cabinet 10, due to a pressure on the panel 16, the other edges 22 detach from the wall 12, the one edge 20 stays attached to the wall 12 and the panel 16 bends away from the wall 12 around the one edge 20.

This can be achieved in different ways. As shown in Fig. 1, the distance of neighbouring attachment devices 18 at the one edge 20 is shorter than the distance of neighbouring attachment devices 18 at the other edges 22. In this way, a density of the attachment devices 18 at the one edge 20 is higher than at the other edges 22 and the attachment of the edge 20 to the wall 12 (per unit length) is stronger as for the other edges 22. In Fig. 1, the attachment devices 18 at the one edge 20 and at the other edges 22 are equally designed, but have different distances.

Other possibilities are to use other types of attachment devices 18 for the different edges 20, 22 and/or to reinforce the attachments at the one edge 20, for example by reinforcing the wall 12 and/or the panel 16, where they are attached with each other at the one edge 20. These possibilities and also the different densities of the attachment devices 18 may be combined with each other.

In Fig. 1 and 2, the edge 20 with the stronger attachment is one of the longest edges of the panel 16.

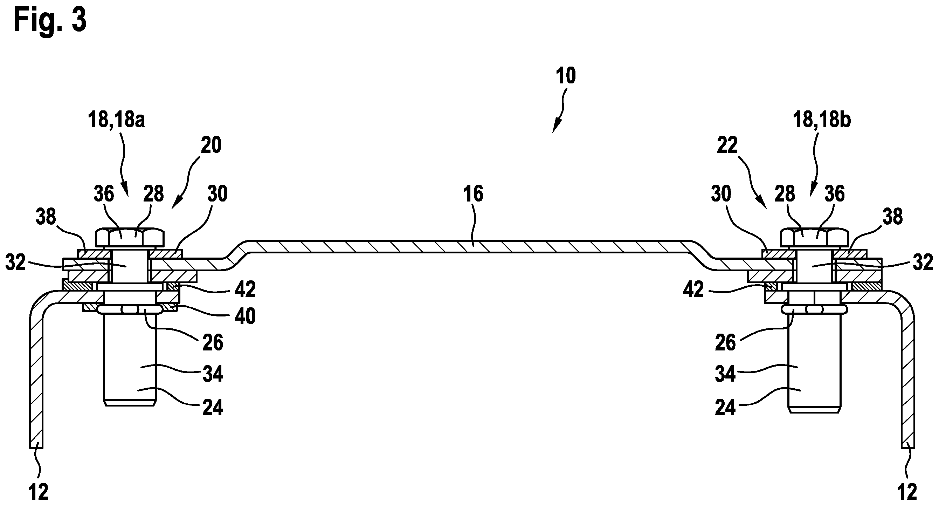

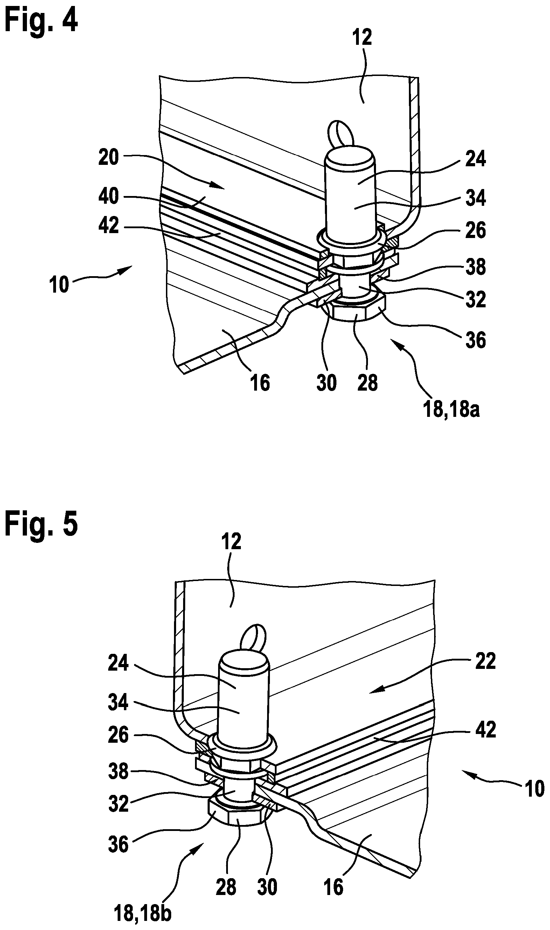

Fig. 3 to 4 show a further embodiment of a cabinet 10, where the attachment devices 18a at the edge 20 are reinforced, while this is not done with the attachment devices 18b at the edge 22. Solely one attachment device 18a, 18b is shown for each edge 20, 22. However, further attachment devices 18a, 18b below or above the plane of the cross-section are present.

The embodiment of Fig. 3 to 4 may be combined with the one of Fig. 1 or 2, i.e. the distance of attachment devices 18a may be smaller as the ones of the attachment devices 18b.

Each attachment device 18a, 18b comprises an interior part 24 with an interior rim 26 pressed towards an interior side of the wall 12 and an exterior part 28 with an exterior rim 30 connected to the interior part 24 and pressed against an outer side of the panel 16. Each attachment device 18 comprises a bolt 32 protruding through the panel 16 and the wall 12. The interior part 24 with the interior rim 26 is provided by a blind rivet nut 34. The exterior part 28 with the exterior rim is provided by a screw 36 with washer 38. The bolt 32 is the shaft of the screw 36.

At the edge 20, a reinforcement plate 40 is arranged between the wall 12 and the interior rim 26 of the interior part 24 of the attachment device 18a. The reinforcement plate 40, which may be made of steel, comprises a hole through which the bolt 32 of the attachment device 18a protrudes. At the other edge 22, no reinforcement plate 40 or a thinner and/or weaker reinforcement plate 40 may be present.

The reinforcement plate 40 may be a strip with several holes for more than one attachment device 18a.

It also may be that at the one edge 20, the washer 38 (which may be seen as further reinforcement plate), which is arranged between the panel 16 and screw 36 of the attachment devices 18a, is thicker and/or stronger than the washer 38 of the attachment devices 18b. This is a further possibility for generating a stronger attachment at the edge 20 compared to the edge 22.

For sealing the interior of the cabinet 10 from environment conditions, at the edges 20, 22, a sealing strip 42 is arranged between the wall 12 and the panel 16. The sealing strip 42 also comprises holes through which the bolt 32 of the attachment devices 18, 18a 18b, protrude. The sealing strip 42 may be made of an elastic material such as rubber.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art and practising the claimed invention, from a study of the drawings, the disclosure, and the appended claims, as long as such variations fall under the scope of the appended claims.

In the claims, the word "comprising" does not exclude other elements or steps, and the indefinite article "a" or "an" does not exclude a plurality. A single processor or controller or other unit may fulfil the functions of several items recited in the claims. The mere fact that certain measures are recited in mutually different dependent claims does not indicate that a combination of these measures cannot be used to advantage. Any reference signs in the claims should not be construed as limiting the scope.

### LIST OF REFERENCE SYMBOLS

- 10: cabinet
- 12: wall
- 14: terminal
- 16: panel
- 18: attachment device
- 18a: first type of attachment device
- 18b: second type of attachment device
- 20: reinforced edge
- 22: normal edge
- 24: interior part
- 26: interior rim
- 28: exterior part
- 30: exterior rim
- 32: bolt
- 34: blind rivet nut
- 36: screw
- 38: washer
- 40: reinforcement plate
- 42: sealing strip

## Claims

1. A cabinet (10) for power electronics components,
wherein the cabinet (10) comprises walls (12) for enclosing an interior of the cabinet (10), in which the power electronics components are arranged;
wherein one of the walls (12) comprises a panel (16), which is attached with each of its edges (20, 22) to the wall (12) with a plurality of attachment devices (18);
wherein at least one section of one edge (20) of the edges is stronger attached to the wall (12) than the other edges (22), such that in case of an explosion in the interior of the cabinet (10), due to a pressure on the panel (16), the other edges (22) detach from the wall (12), the one edge (20) stays attached to the wall (12) and the panel (16) bends away from the wall (12) around the one edge (20); **characterized by**
wherein each attachment device (18) comprises an interior part (24) with an interior rim (26) pressed towards an interior side of the wall (12) and an exterior part (28) with an exterior rim (30) connected to the interior part (24) and pressed against an outer side of the panel (16);
wherein each attachment device (18) protrudes through the panel (16) and the wall (12);
wherein at the one edge (20), a reinforcement plate (40) is arranged between the wall (12) and the interior rim (26) of the interior part (24) of at least some of the attachment devices (18a).

2. The cabinet (10) of claim 1,
wherein the one edge (20) is one of the longest edges of the panel (16).

3. The cabinet (10) of claim 1 or 2,
wherein the panel (16) is a rectangular panel.

4. The cabinet (10) of claim 1 or 2,
wherein a density of the attachment devices (18) at the one edge (20) is higher than at the other edges (22).

5. The cabinet (10) of one of the previous claims,
wherein the attachment devices (18) at the one edge (20) are equally designed and wherein the attachment devices (18) at the other edges (22) are equally designed.

6. The cabinet (10) of one of the previous claims,
wherein the attachment devices (18) are arranged in rows along the edges (20, 22);
wherein a distance of neighbouring attachment devices (18) at the one edge (20) is shorter than a distance of neighbouring attachment devices (18) at the other edges.

7. The cabinet (10) of one of the previous claims,
wherein the interior part (24) comprises a rivet blind head and the exterior part (28) comprises a rivet head; and/or
wherein the interior part (24) comprises a nut and the exterior (28) part comprises a screw.

8. The cabinet (10) of one of the previous claims,
wherein at the one edge (20), a reinforcement plate (40) is arranged between the panel (16) and the exterior rim (30) of the exterior part (28) of at least some of the attachment devices (18a).

9. The cabinet (10) of one of the previous claims,
wherein the at least some of the attachment devices (18a) protrude through the reinforcement plate (40).

10. The cabinet (10) of one of the previous claims,
wherein the reinforcement plate (40) is made of steel.

11. The cabinet (10) of one of the previous claims,
wherein at the one edge (20) and the other edges (22), a sealing strip (42) is arranged between the wall (12) and the panel (16).

12. The cabinet (10) of one of the previous claims,
wherein the walls (12) of the cabinet (10) are made of aluminium alloy.

13. The cabinet (10) of one of the previous claims,
wherein the panel (16) is made of aluminium alloy.

14. The cabinet (10) of one of the previous claims, wherein the power electronics components comprise at least one of:
batteries;
inverter components;
switch gear components.

## Patentansprüche

1. Schrank (10) für Leistungselektronikkomponenten, wobei der Schrank (10) Wände (12) zum Umschließen eines Innenraums des Schranks (10) umfasst, in denen die Leistungselektronikkomponenten angeordnet sind;
wobei eine der Wände (12) eine Platte (16) umfasst, die mit jeder ihrer Kanten (20, 22) mit mehreren Befestigungsvorrichtungen (18) an der Wand (12) befestigt ist;
wobei mindestens ein Abschnitt einer Kante (20) der Kanten stärker an der Wand (12) angebracht ist als die anderen Kanten (22), so dass im Fall einer Explosion im Inneren des Schranks (10) aufgrund eines Drucks auf die Platte (16) die anderen Kanten (22) sich von der Wand (12) lösen, die eine Kante (20) an der Wand (12) angebracht bleibt und die Platte (16) sich um die eine Kante (20) von der Wand (12) weg biegt; **gekennzeichnet durch**
wobei jede Befestigungsvorrichtung (18) ein Innenteil (24) mit einem Innenrand (26), der zu einer Innenseite der Wand (12) gedrückt wird, und ein Außenteil (28) mit einem Außenrand (30), der mit dem Innenteil (24) verbunden ist und gegen eine Außenseite der Platte (16) gedrückt wird, umfasst;
wobei jede Befestigungsvorrichtung (18) durch die Platte (16) und die Wand (12) vorsteht;
wobei an dem einen Rand (20) eine Verstärkungsplatte (40) zwischen der Wand (12) und dem Innenrand (26) des Innenteils (24) von mindestens einigen der Befestigungsvorrichtungen (18a) angeordnet ist.

2. Schrank (10) nach Anspruch 1;
wobei die eine Kante (20) eine der längsten Kanten der Platte (16) ist.

3. Schrank (10) nach Anspruch 1 oder 2;
wobei die Platte (16) eine rechteckige Platte ist.

4. Schrank (10) nach Anspruch 1 oder 2;
wobei eine Dichte der Befestigungsvorrichtungen (18) an der einen Kante (20) höher als an den anderen Kanten (22) ist.

5. Schrank (10) nach einem der vorstehenden Ansprüche, wobei die Befestigungsvorrichtungen (18) an der einen Kante (20) gleich ausgebildet sind und wobei die Befestigungsvorrichtungen (18) an den anderen Kanten (22) gleich ausgebildet sind.

6. Schrank (10) nach einem der vorstehenden Ansprüche,
wobei die Befestigungsvorrichtungen (18) in Reihen entlang der Kanten (20, 22) angeordnet sind;
wobei ein Abstand benachbarter Befestigungsvorrichtungen (18) an der einen Kante (20) kürzer ist als ein Abstand benachbarter Befestigungsvorrichtungen (18) an den anderen Kanten.

7. Schrank (10) nach einem der vorstehenden Ansprüche, wobei das Innenteil (24) einen Nietblindkopf umfasst und das Außenteil (28) einen Nietkopf umfasst; und/oder wobei das Innenteil (24) eine Mutter umfasst und das Außenteil (28) eine Schraube umfasst.

8. Schrank (10) nach einem der vorstehenden Ansprüche, wobei an der einen Kante (20) eine Verstärkungsplatte (40) zwischen der Platte (16) und dem Außenrand (30) des Außenteils (28) von mindestens einigen der Befestigungsvorrichtungen (18a) angeordnet ist.

9. Schrank (10) nach einem der vorstehenden Ansprüche, wobei die mindestens einigen der Befestigungsvorrichtungen (18a) durch die Verstärkungsplatte (40) vorstehen.

10. Schrank (10) nach einem der vorstehenden Ansprüche, wobei die Verstärkungsplatte (40) aus Stahl hergestellt ist.

11. Schrank (10) nach einem der vorstehenden Ansprüche, wobei an der einen Kante (20) und den anderen Kanten (22) ein Dichtungsstreifen (42) zwischen der Wand (12) und der Platte (16) angeordnet ist.

12. Schrank (10) nach einem der vorstehenden Ansprüche, wobei die Wände (12) des Schranks (10) aus einer Aluminiumlegierung hergestellt sind.

13. Schrank (10) nach einem der vorstehenden Ansprüche, wobei die Platte (16) aus einer Aluminiumlegierung hergestellt ist.

14. Schrank (10) nach einem der vorhergehenden Ansprüche, wobei die Leistungselektronikkomponenten mindestens eines von Folgendem umfassen:
Batterien;
Wechselrichterkomponenten;
Schaltanlagenkomponenten.

## Revendications

1. Armoire (10) pour composants électroniques de puissance,
l'armoire (10) comprenant des parois (12) pour délimiter un intérieur de l'armoire (10), dans lequel les composants électroniques de puissance sont disposés ; l'une des parois (12) comportant un panneau (16) qui est fixé avec chacun de ses bords (20, 22) à la paroi (12) avec une pluralité de dispositifs de fixation (18) ;
au moins une section d'un bord (20) parmi les bords étant fixée à la paroi (12) d'une manière plus résistante que les autres bords (22), de sorte qu'en cas d'explosion à l'intérieur de l'armoire (10), sous l'effet d'une pression sur le panneau (16), les autres bords (22) se détachent de la paroi (12), ledit bord (20) reste attaché à la paroi (12) et le panneau (16) se plie de façon à s'écarter de la paroi (12) autour dudit bord (20) ; **caractérisée par**
chaque dispositif de fixation (18) comportant une partie intérieure (24) avec un rebord intérieur (26) pressée vers un côté intérieur de la paroi (12) et une partie extérieure (28) avec un rebord extérieur (30) reliée à la partie intérieure (24) et pressée contre un côté extérieur du panneau (16) ;
chaque dispositif de fixation (18) faisant saillie à travers le panneau (16) et la paroi (12) ;
une plaque de renforcement (40) étant disposée, au niveau dudit bord (20), entre la paroi (12) et le rebord intérieur (26) de la partie intérieure (24) d'au moins une partie des dispositifs de fixation (18a).

2. Armoire (10) selon la revendication 1,
dans laquelle ledit bord (20) est l'un des bords les plus longs du panneau (16).

3. Armoire (10) selon la revendication 1 ou 2,
dans laquelle le panneau (16) est un panneau rectangulaire.

4. Armoire (10) selon la revendication 1 ou 2,
dans laquelle une densité des dispositifs de fixation (18) au niveau dudit bord (20) est plus élevée qu'au niveau des autres bords (22).

5. Armoire (10) selon l'une des revendications précédentes,
dans laquelle les dispositifs de fixation (18) au niveau dudit bord (20) sont conçus de la même façon et dans laquelle les dispositifs de fixation (18) au niveau des autres bords (22) sont conçus de la même façon.

6. Armoire (10) selon l'une des revendications précédentes,
dans laquelle les dispositifs de fixation (18) sont disposés en rangées le long des bords (20, 22) ;
dans laquelle une distance des dispositifs de fixation (18) voisins au niveau dudit bord (20) est plus courte qu'une distance des dispositifs de fixation (18) voisins au niveau des autres bords.

7. Armoire (10) selon l'une des revendications précédentes,
dans laquelle la partie intérieure (24) comprend une tête borgne de rivet et la partie extérieure (28) comprend une tête de rivet ; et/ou
dans laquelle la partie intérieure (24) comprend un écrou et la partie extérieure (28) comprend une vis.

8. Armoire (10) selon l'une des revendications précédentes,
dans laquelle une plaque de renforcement (40) est disposée, au niveau dudit bord (20), entre le panneau (16) et le rebord extérieur (30) de la partie extérieure (28) d'au moins une partie des dispositifs de fixation (18a).

9. Armoire (10) selon l'une des revendications précédentes,
dans laquelle l'au moins une partie des dispositifs de fixation (18a) font saillie à travers la plaque de renforcement (40).

10. Armoire (10) selon l'une des revendications précédentes,
dans laquelle la plaque de renforcement (40) est en acier.

11. Armoire (10) selon l'une des revendications précédentes,
dans laquelle une bande d'étanchéité (42) est disposée, au niveau dudit bord (20) et des autres bords (22), entre la paroi (12) et le panneau (16).

12. Armoire (10) selon l'une des revendications précédentes,
dans laquelle les parois (12) de l'armoire (10) sont en alliage d'aluminium.

13. Armoire (10) selon l'une des revendications précédentes,
dans laquelle le panneau (16) est en alliage d'aluminium.

14. Armoire (10) selon l'une des revendications précédentes, dans laquelle les composants électroniques de puissance comprennent au moins l'un des suivants :
batteries ;
composants d'onduleur ;
composants d'appareillage de commutation.
